# FASCICULE DE BREVET EUROPEEN

(11) **EP 3 894 170 B1**
(45) Date de publication et mention de la délivrance du brevet: **09.11.2022**
(21) Numéro de dépôt: 19816737.1
(22) Date de dépôt: 11.12.2019
(51) Int. Cl.: B29C 33/38, B29C 33/40, B29C 35/02, B29C 35/08, B29C 41/04, G03F 7/00, B29C 33/60, B29K 101/10, B29K 105/24

(54) **PROCÉDÉ DE FABRICATION D'UN MOULE DE LITHOGRAPHIE POUR IMPRESSION NANOMÉTRIQUE**
VERFAHREN ZUR HERSTELLUNG EINER NANOIMPRINT-LITHOGRAFIEFORM
METHOD FOR MANUFACTURING A NANOIMPRINT LITHOGRAPHY MOLD

(30) Priorité: 13.12.2018 FR 1872888
(43) Date de publication de la demande: 20.10.2021
(73) Titulaire: Commissariat à l'Energie Atomique et aux Energies Alternatives, 75015 Paris (FR)
(72) Inventeur: TEYSSEDRE, Hubert, 38054 Grenoble Cedex 09 (FR); LANDIS, Stefan, 38054 Grenoble Cedex 09 (FR); MAY, Michael, 38054 Grenoble CEDEX 09 (FR)
(74) Mandataire: Hautier IP
(86) Numéro de dépôt international: PCT/EP2019/084754
(87) Numéro de publication internationale: WO 2020/120627

(56) Documents cités:
- WO-A1-2018/166896
- US-A1- 2012 152 887
- US-A1- 2012 286 454
- US-A1- 2015 024 308
- FAHMI SAMSURI ET AL: "Formation of Nanoscale Bioimprints of Muscle Cells Using UV-Cured Spin-Coated Polymers", JOURNAL OF NANOTECHNOLOGY, vol. 2009, 1 janvier 2009 (2009-01-01), pages 1-6, XP055609164, ISSN: 1687-9503, DOI: 10.1155/2009/593410

## Description

### DOMAINE TECHNIQUE

La présente invention concerne en général la lithographie et plus particulièrement la lithographie par impression nanométrique.

### ÉTAT DE LA TECHNIQUE

Parmi les techniques de lithographie mises en oeuvre par l'industrie de la microélectronique pour la production de circuits intégrés et, plus généralement, de circuits pouvant combiner composants électroniques, optiques et mécaniques, la technique d'impression nanométrique suscite un intérêt croissant. Cette technique repose sur l'impression, avec un moule, d'une résine déformable. Le moule comporte des motifs qui sont transférés dans la résine lors de l'impression et dont les dimensions sont généralement comprises entre quelques nanomètres et plusieurs dizaines voire centaines de micromètres. Dans ce contexte, les techniques standards de nano impression font actuellement usage de deux types de moules : des moules dits « rigides » et des moules dits « souples ».

Un avantage des moules rigides, par exemple basés sur des substrats de silicium, est leur résistance mécanique, les rendant largement réutilisables.

En ce qui concerne les moules souples, typiquement en matériaux organiques (les matériaux peuvent aussi être hybrides, c'est-à-dire composés d'une matrice organique mais chargés en particules ou matière minérales, comme le silicium, les métaux, des diélectriques), leur avantage principal est la capacité qu'ils procurent de pouvoir réaliser un contact conforme sur toute la surface à imprimer, ce qui permet d'optimiser l'uniformité de pressage et ainsi d'obtenir une distribution plus homogène. Ils sont donc généralement mis en œuvre pour imprimer de grandes surfaces, par exemple pour des substrats dont le diamètre est supérieur à 100 mm. En outre, leur souplesse permet de réduire les risques de casse en présence de poussières entre la surface à imprimer et le moule. Un autre avantage est qu'ils sont réalisés avec des matériaux organiques ou hybrides à partir d'un moule-mère ou encore moules maître de l'anglais « master mould ». Une face de ce moule présente des motifs formant une surface de conformation des moules souples et présentant l'image en négatif du relief à conférer aux moules souples qui en sont issus. Les copies à partir du moule-mère sont alors moins coûteuses à fabriquer tout en préservant l'original qui ne sera utilisé que pour faire d'autres copies. Au surplus, le démoulage du moule flexible imprimé dans la résine de lithographie est facilité car on peut le réaliser par pelage.

Le moule maître est en lui-même généralement réalisé grâce aux technologies de la micro et de la nano électronique sur des substrats, par exemple de matériaux semi-conducteurs, du silicium en particulier. En effet, sur cette base, on dispose de procédés nombreux pour réaliser une pluralité de formes avec des dimensions caractéristiques ayant de grandes résolutions, typiquement de l'ordre de quelques nanomètres.

La fabrication du moule flexible est actuellement réalisée par l'intermédiaire de deux types de procédés.

Le premier type est de nature thermique. Un film plastique fin (de quelques dizaines à quelques centaines de micromètres d'épaisseur) est pressé pour être mis en forme sur le moule maître à une température supérieure à sa température de transition vitreuse. Après refroidissement en dessous de cette température, le film mis en forme est démoulé. Cette méthode a l'avantage de la simplicité mais elle subit les dilatations thermiques impliquées par l'élévation de température au-dessus de la température de transition vitreuse du matériau du film. Les écarts de coefficient de dilatation entre ce dernier matériau et celui du moule maître induisent que le moule flexible n'est pas une copie parfaitement fidèle du moule maître. Généralement le moule souple est contracté par rapport au moule maître.

Une alternative à cette méthode utilise une insolation pour réticuler un matériau organique liquide destiné à former au moins une partie du moule flexible. L'utilisation d'une source de lumière permet de travailler à température plus basse que dans le cas précédent, et notamment à température ambiante, de sorte que les problématiques de dilatation thermique sont éliminées.

Suivant une première option, un matériau organique liquide qui peut être insolé est déposé sur le moule maître. Cela conduit à former une couche d'une épaisseur par exemple de quelques micromètres. Un film en matière plastique est alors laminé sur l'empilement que forment le moule maître et la couche de matériau organique liquide. L'ensemble est ensuite exposé à une lumière, comprenant une longueur d'onde ou un intervalle de longueurs d'onde auquel le matériau liquide est sensible (habituellement dans la gamme des ultraviolets, par exemple avec une lampe à mercure). Le matériau organique ou hybride est ainsi photo polymérisé. Il présente une adhésion préférentielle sur le film en matière plastique plutôt que sur la surface du moule maître ce qui permet alors le pelage du film et de la couche organique polymérisée formant le moule souple et disposant d'une image inverse des motifs présents sur le moule maître.

Suivant une deuxième option, le film en matière plastique est initialement recouvert du matériau organique photosensible (avec des épaisseurs généralement de plusieurs micromètres). Un report sur le moule maître assure le moulage. Ensuite, le matériau organique ou hybride (pour le moins la matrice organique dans ce dernier cas) est solidifié par une illumination avec une source de lumière. Comme dans le cas précédent, le démoulage se fait par pelage.

Dans tous les cas, il est possible d'ajouter sur la surface de conformation du moule maître un revêtement antiadhésif qui va faciliter le démoulage ou le pelage du moule souple fabriqué et qui élimine ou réduit la présence de composés organiques résiduels du moule souple à la surface du moule maître.

Un inconvénient des techniques connues pour les moules souples, en particulier avec l'emploi d'un matériau organique sous forme liquide, est qu'il faut assurer une bonne répartition de la couche polymérisée issue de ce matériau sur le moule maître. Tout défaut de répartition engendre un manque de fidélité de la copie relativement au moule maître.

On connait par ailleurs de la publication brevet US2015024308A un moule flexible de nanoimpression qui comprend une couche supérieure très fine. La publication scientifique « FAHMI SAMSURI ET AL, "Formation of Nanoscale Bioimprints of Muscle Cells Using UV-Cured Spin-Coated Polymers", JOURNAL OF NANOTECHNOLOGY, (20090101), vol. 2009, doi:10.1155/2009/593410, ISSN 1687-9503, pages 1 - 6, XP055609164 » présente une technique de réalisation d'éléments de cellules musculaires par l'intermédiaire de matériau polymère déposé par étalement et réticulé. La publication brevet US 2012/0286454 A1 présente un dispositif en deux parties articulées pour la réalisation d'un moule ayant des microstructures. La publication brevet WO 2018/166896 A1 révèle un autre moule de nano impression. La publication brevet US 2012/0152887 A1 décrit un procédé de réalisation d'un moule de nano impression avec des étapes de réalisation de nano structures.

Un objet de la présente invention est de proposer un procédé qui permette de pallier au moins en partie les inconvénients des procédés existants.

### RÉSUMÉ

La présente invention prévoit un procédé de fabrication d'un moule de lithographie pour impression nanométrique, comprenant successivement:
- un dépôt d'une couche comprenant un matériau liquide polymérisable sur une surface de conformation située sur une face d'un moule maitre, le dépôt comprenant un étalement du matériau par revêtement par centrifugation de sorte à atteindre un état de couverture de la couche sur toute la surface de conformation ;
- une polymérisation de la couche tout en poursuivant la centrifugation ;
- un placement d'un film polymère sur la couche.

Ainsi, l'état de couverture produit par l'étalement centrifuge (encore dénommé spin-coating) est préservé par une polymérisation, sans possibilité de retrait (ou avec une diminution du retrait), du matériau entre la phase de dépôt et celle de la polymérisation puisque la centrifugation n'est pas arrêtée au moins pour une phase primaire de la polymérisation. L'état de couverture est donc amélioré voire maintenu en totalité jusqu'à la polymérisation finale.

La conformation du matériau est alors plus fidèle qu'avec les techniques existantes, en particulier de fabrication de moules souples.

On procède, après polymérisation, à un placement d'un film polymère sur la couche.

Également divulgué est un moule obtenu par le procédé selon l'invention.

Également divulgué est un procédé comprenant une phase de fabrication d'un moule, et une phase de nano-impression utilisant ce moule.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
- la figure 1 montre un exemple de conformation possible d'un moule maître utilisable avec l'invention ;
- la figure 2 présente une étape non limitative de dépôt d'un matériau antiadhésif
- la figure 3 illustre la formation d'une couche par revêtement par centrifugation ;
- la figure 4 schématise une polymérisation au cours de la centrifugation ;
- la figure 5 est le résultat de l'opération produite à la figure 4 ;
- la figure 6 indique la mise en place d'un film sur la couche déposée par centrifugation ;
- la figure 7 concerne une polymérisation additionnelle ;
- la figure 8 présente un moule finalisé disposé sur le moule maître.

Les dessins sont donnés à titre d'exemples.

Ils constituent des représentations schématiques de principe destinées à faciliter la compréhension de l'invention et ne sont pas nécessairement à l'échelle des applications pratiques. En particulier, les épaisseurs relatives des différentes couches ne sont pas représentatives de la réalité. Dans la présente demande de brevet, l'épaisseur est prise selon une direction perpendiculaire aux faces principales du substrat sur lequel repose les différentes couches. Sur les figures, l'épaisseur est prise selon la verticale.

### DESCRIPTION DÉTAILLÉE

Avant d'entamer une revue détaillée des modes de réalisation de l'invention, sont énoncées ci-après des caractéristiques optionnelles du premier aspect de l'invention qui peuvent éventuellement être utilisées en association ou alternativement :
- la polymérisation est une polymérisation partielle du matériau;
- la polymérisation partielle est suivie d'une polymérisation additionnelle ;
- la polymérisation additionnelle est configurée pour polymériser totalement le matériau ;
- le placement d'un film 4 polymère est opéré sur la face exposée de la couche 3, avant la polymérisation additionnelle ;
- la polymérisation est une polymérisation thermique ;
- la polymérisation est une photo polymérisation ;
- avantageusement, on peut aussi réaliser la photo polymérisation sous flux gazeux en particulier d'azote (N2) pour les matériaux photosensibles inhibés par l'oxygène présent dans l'air ;
- la photo polymérisation est opérée en appliquant au matériau une dose comprise entre 5 et 10% de la dose de polymérisation totale de la couche 3;
- la polymérisation est configurée pour atteindre un niveau de polymérisation au moins suffisant pour assurer la persistance de l'état de couverture de la couche 3 sur toute la surface de conformation 11 après arrêt de la centrifugation et au moins durant un temps prédéterminé ;
- la polymérisation est configurée pour atteindre un niveau de polymérisation au moins suffisant pour que la vitesse de retrait du matériau soit inférieure ou égale à 1mm/heure
- le procédé selon l'invention comprend le dépôt d'un revêtement antiadhésif 2 sur la surface de conformation 11 avant le dépôt de la couche 3.

Il est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant, soit directement à son contact, soit en étant séparée d'elle par au moins une autre couche ou au moins un autre élément.

D'une manière générale, la présente invention permet la fabrication de moules de lithographie utilisables dans le contexte de la nano impression, et ces moules peuvent être utilisés pour la fabrication de dispositifs micro-électroniques. Par dispositif ou élément de dispositif microélectronique, on entend tout type de dispositif ou d'élément réalisé avec les moyens de la microélectronique. Ces dispositifs englobent notamment, en plus des dispositifs à finalité purement électronique, des dispositifs micromécaniques ou électromécaniques (MEMS, NEMS...) ainsi que des dispositifs optiques ou optoélectroniques (MOEMS...).

L'objet de l'invention est notamment un procédé de fabrication de moules sur la base d'un moule maître. Les moules issus de ce procédé comprennent, non exclusivement, ceux typiquement connus sous le vocable « moules souples ».

Un tel moule peut comporter au moins une couche comprenant un matériau polymère déposé sous forme liquide puis polymérisé. Cette couche sert avantageusement à la définition, en négatif du moule maître, de motifs sur l'une de ces faces. Suivant une possibilité, la couche consiste en ledit matériau polymérisable ; ce dernier peut être un mélange de polymères différents. Suivant une autre possibilité, la couche comprend aussi des charges dans une matrice faite du matériau polymérisable, formant ainsi une couche de matière hybride ou composite ; les charges peuvent non exclusivement comprendre au moins un parmi : des particules ou des matières minérales, comme le silicium ou d'autres semi-conducteurs, des métaux, des matériaux diélectriques.

Il peut aussi comporter un film en matériau polymère solidarisé à la couche précédemment indiquée par la face opposée à celle comportant les motifs. L'invention n'exclut pas que le moule comporte d'autres parties. De plus, la couche de reproduction des motifs peut elle-même comporter des sous-couches, avec par exemple une première sous-couche plus dure contenant les motifs et une deuxième sous-couche, moins dure, surmontant la première, à l'opposé des motifs.

L'épaisseur du moule peut être inférieure à 1 mm.

D'une manière générale, le caractère souple d'un moule s'entend alternativement ou cumulativement :
- de sa capacité de déformation élastique permettant de garantir sa conformabilité au niveau de ses portions en contact avec la surface à imprimer lors des impressions ;
- de sa capacité à être déformé en deçà de sa limite élastique lors d'au moins une étape d'utilisation du moule, telle qu'un laminage sur une surface à imprimer, un pelage ;
- d'un module d'élasticité inférieur à 1 GPa, de son matériau ou de ses matériaux;
- d'une capacité de déformation en flexion du moule avec un rayon de courbure de moins d'un mètre, voire de moins de 5 cm, et éventuellement inférieur ou égal à 1 cm.

L'invention vise notamment à permettre le dépôt d'un matériau organique visqueux, généralement photosensible, avec la technique de la tournette (généralement dénommée « spin coating » que l'on peut traduire littéralement par revêtement par centrifugation ou par rotation) de sorte à ce que le moule soit aussi fidèle que possible au moule maître.

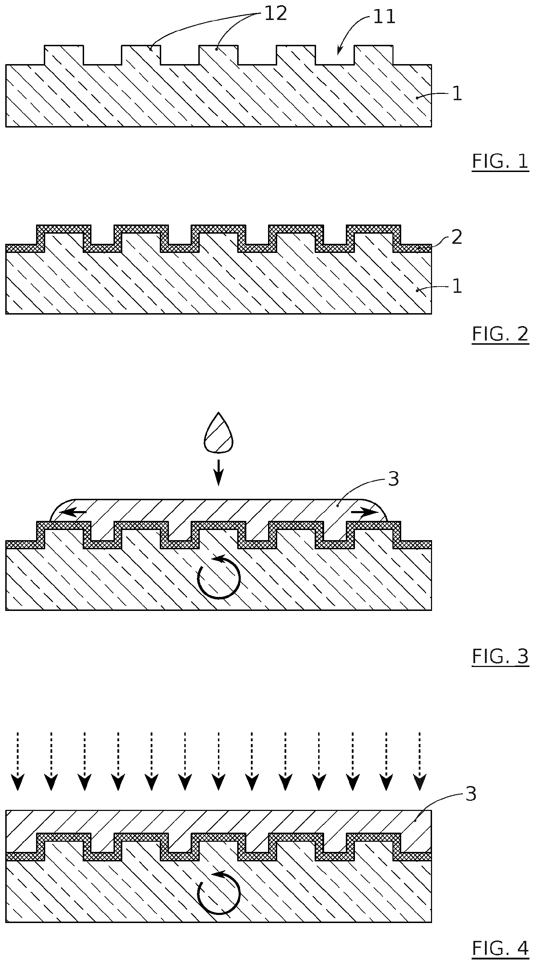

La figure 1 présente le contexte d'un moule maître 1 dont une face comporte, sur au moins une partie de sa surface, des motifs tels que ceux illustrés purement schématiquement sous la référence 12 à la figure 1. La surface équipée des motifs est ici dénommée surface de conformation 11. C'est sur cette dernière que l'on va fabriquer au moins un moule destiné à l'impression nanométrique. En effet, le ou les motifs 12 de la surface de conformation 11 sont destinés à être reportés sur ce moule qui servira lui-même, par impression d'une couche imprimable disposée sur un substrat, à reproduire les motifs 12 en vue d'un traitement par lithographie du substrat, qui peut typiquement être à base de semi-conducteurs, et notamment à base de silicium. La surface de conformation 11 peut être toute la superficie de la face du moule maître 1, ou seulement une partie de cette superficie, par exemple centrée sur la face en question du moule maître.

Le moule maître 1 peut, en lui-même, au moins sur une partie de son épaisseur dont la face est la zone exposée, être en un matériau semi-conducteur, en particulier du silicium ou de l'oxyde de silicium ou du nitrure de silicium. De manière bien connue, ce type de matériau peut subir des étapes de définition de reliefs bien maîtrisées par les technologies de la micro-électronique.

La figure 2 montre une étape non limitative de l'invention selon laquelle un revêtement antiadhésif 2 est formé sur la surface de conformation 11 de la face du moule maître 1. On cherche ainsi à réduire les forces d'adhésion de sorte à faciliter le démoulage ou encore le pelage du moule souple une fois ce dernier fabriqué, et empêcher autant que faire se peut de laisser des composés organiques issus de la fabrication du moule souple sur le moule maître. Notamment, on peut avoir recours à un matériau antiadhésif de la société Daikin et portant la dénomination Optool DSX^{®}. Typiquement, on peut utiliser un matériau ayant une énergie de surface inférieure à 20 mJ/cm² et par exemple de l'ordre de 11 mJ/cm². De préférence, cette énergie de surface est choisie inférieure à celle du matériau liquide polymérisable qui sera utilisé ensuite pour constituer le moule souple proprement dit. Généralement, une couche unique de matériau antiadhésif suffira. La formation de ce revêtement peut se faire par une technique de déposition telle que le dépôt en phase vapeur généralement connu sous son acronyme anglais PVD ou la technique de dépôt chimique en phase vapeur connu sous l'acronyme anglais CVD.

La figure 3 révèle l'application d'un matériau liquide polymérisable sur la surface de conformation de sorte à produire une couche 3. Ce matériau est destiné à subir une réticulation et se présente initialement sous sa forme liquide non réticulée. Des matériaux utilisables sont par exemple connus sous l'expression «working stamp material (WSM) » que l'on peut traduire par matériau de travail d'impression. D'un point de vue chimique, il peut s'agir non exclusivement de polydiméthylsiloxane ou encore de polymères fluorés dérivés du téflon ou de matériaux de la famille des Poly Urethane Acrylate (PUA).

De manière préférée, cette application utilise la technique du revêtement par centrifugation. Dans ce cadre, la face du moule maître 1, opposée à la face comportant les motifs 12, est disposée sur un plateau qui peut être actionné suivant un mouvement de rotation propre tel que le schématise la flèche visible à la figure 3. De préférence, le centre de la surface de conformation 11 de la face est aligné sur l'axe de rotation (s'agissant notamment de plaques de section circulaire, par exemple d'un diamètre de 200 mm, le centre est typiquement le centre de contour circulaire de la plaque). Durant cette rotation, le matériau liquide est progressivement déposé au niveau de la surface 11, préférentiellement sous forme de goutte-à-goutte et avantageusement au centre de la surface de conformation. On comprend que la force centrifuge induit une application progressive du matériau liquide depuis le centre vers la périphérie de la surface de conformation. Les flèches horizontales de la figure 3 montrent cette propension à l'étalement.

Le résultat visé par cette technique est un étalement du matériau liquide sur l'intégralité de la surface de conformation 11 de la face du moule maître. Un tel état de couverture complet est représenté à la figure 4 au niveau de laquelle la couche 3 réalisée par centrifugation recouvre l'ensemble de la face exposée du moule maître.

On comprend aisément que le matériau ainsi déposé, surtout s'il est au contact d'une surface de faible énergie de surface, comme celle d'un revêtement antiadhésif, subit un phénomène de retrait par effet capillaire sur son support si la rotation est arrêtée. Ce retrait se fait par défaut, soit depuis les bords extérieurs de la surface de conformation 11, soit depuis des défauts particulaires présents à la surface du moule maître 1. Ainsi, par exemple, si la rotation du plateau de centrifugation est stoppée, sans autre précaution, dans l'état de couverture présenté à la figure 4, le retrait tendra à revenir à la configuration de couche 3 visible à la figure 3. La fidélité du moule, issu de la couche 3, en sera affectée.

Le retrait est plus ou moins important selon le temps d'attente inhérent au déplacement du moule maître depuis l'appareil de revêtement par centrifugation vers d'autres postes de fabrication, notamment un module de laminage ou encore un module d'insolation. Il dépend aussi de l'énergie de surface du matériau liquide polymérisable, de celle du revêtement antiadhésif s'il y en a 1, de l'angle de contact du matériau liquide polymérisable, de la viscosité de la couche organique utilisée et du temps d'attente avant l'étape de polymérisation ultérieure. Les conséquences de ce retrait partiel du matériau organique déposé sont d'une part que les parties de la surface de conformation du moule maître non recouvertes par le matériau organique à l'issue de la phase de centrifugation ne seront pas copiées. D'autre part, lorsque des films plastiques sont utilisés, l'adhésion entre la résine imprimée et le film plastique n'est pas optimisé pour permettre un détachement aisé entre ces deux matériaux. Par conséquent on aura dans ces zones la présence de nombreux défauts liés au détachement de ces deux matériaux.

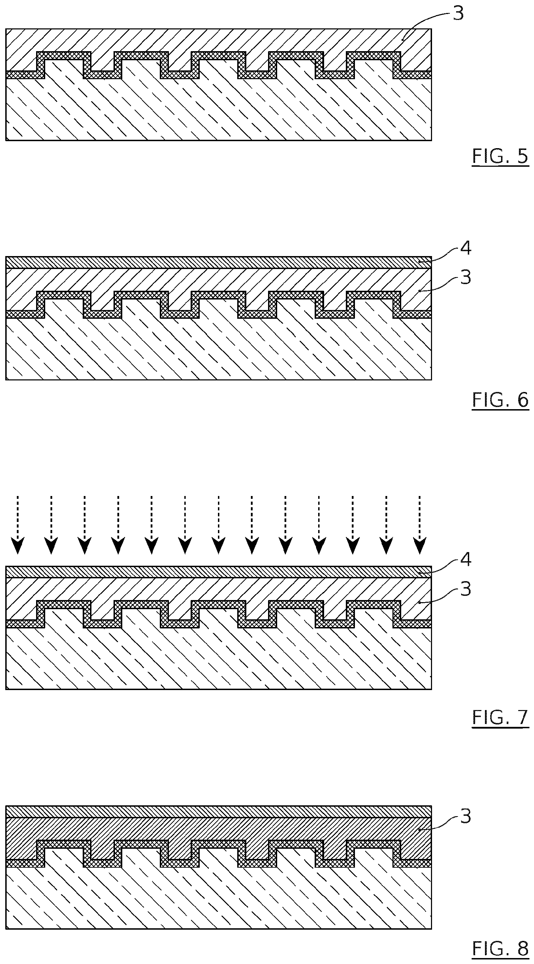

Pour contrer ce phénomène de retrait partiel, ou pour le moins le réduire, la phase reflétée par la figure 4 comprend, durant la rotation du plateau de centrifugation, une polymérisation schématisée par les flèches verticales de cette figure. Il s'ensuit la transformation de la couche étalée en couche 3 transformée, schématisée par des hachures plus denses à la figure 5.

On peut notamment avoir recours à une polymérisation thermique, par exemple par un chauffage au sein de l'appareil de revêtement par centrifugation, par exemple avec un système d'émission d'ondes infrarouges.

On peut aussi utiliser une photo polymérisation. Notamment, l'appareil de revêtement par centrifugation peut être doté, dans une enceinte recevant le moule maître, d'une ou plusieurs sources de lumière, notamment dans le spectre des ultraviolets (en particulier 365 nm). On utilisera, d'une manière générale, une ou des longueurs d'onde auxquelles le matériau liquide polymérisable est sensible. On pourra réaliser la photo polymérisation sous flux d'azote (N2) pour les matériaux photosensibles inhibés par l'oxygène présent dans l'air.

Cette polymérisation, sans arrêter la rotation, permet d'augmenter la viscosité du matériau et donc de réduire, voire de supprimer, la cinétique de démouillage de celui-ci relativement aux motifs 12 de la surface de conformation du moule maître.

Par exemple, le demandeur a pu tester l'efficacité de cette phase de polymérisation en comparant le résultat issu d'une fabrication de la couche 3 sans la polymérisation durant la rotation et le résultat issu d'une fabrication avec, durant la centrifugation, un traitement de photo polymérisation sous UV (365 nm-spectre large) d'une puissance de 40 mW/cm², le tout sur la base d'un substrat de silicium sous forme d'une plaquette de 200 mm de diamètre en utilisant le matériau antiadhésif précité, Optool DSX^{®}. Il s'en est suivi une stabilisation de l'état de couverture complet de la couche sur la surface de conformation en ce qui concerne la fabrication avec photo polymérisation alors que le taux de couverture a été décroissant au cours du temps pour l'échantillon sans traitement UV et ce dès quelques minutes (en particulier moins de cinq minutes à compter de l'arrêt de la rotation).

De préférence, la polymérisation opérée durant le revêtement par centrifugation n'est pas complète de sorte que le matériau initialement non réticulé, n'est que partiellement réticulé par cette étape. De préférence, le niveau de polymérisation atteint par cette étape est suffisant pour stabiliser la couche 3 de sorte à maintenir (après arrêt de la rotation) un état de couverture de la couche 3 sur toute la surface de conformation 11, cette dernière pouvant être identique à l'ensemble de la face.

Suivant une possibilité indicative, la dose reçue par le matériau liquide polymérisable, notamment dans les exemples de matériaux cités ci-dessus, peut-être d'au moins 5 % de la dose de polymérisation totale de la couche 3. De manière alternative ou en complément, cette dose peut être inférieure à 10% de la dose de polymérisation totale, de sorte à maintenir une certaine viscosité pour une capacité d'assemblage de la couche 3 avec un film placé ultérieurement sur la couche 3, comme décrit plus loin.

Notamment, dans le cas d'un matériau photosensible sous UV appliqué sur un substrat de silicium de 200 mm de diamètre, une dose de 9,2 J/cm² peut convenir.

Cumulativement ou alternativement, le degré de polymérisation partielle peut être choisi de sorte à maintenir une vitesse de retrait du matériau inférieure à 1 mm/heure avantageusement. Cette vitesse de retrait pourra dépendre des paramètres suivants, viscosité du matériau, épaisseur, tension de surface, angle de mouillage sur le substrat.

Un procédé de l'invention peut permettre de déterminer un niveau de dose utilisable pour cette phase de polymérisation avantageusement partielle. Dans ce cadre, on considère dans un premier temps un couple de surfaces d'application (la surface de conformation ou la surface du revêtement adhésif 2) et de matériau liquide polymérisable. Si les paramètres de démouillage sont tels que ce dernier va produire un retrait du matériau organique dans une mesure inacceptable pour des critères de fabrication prédéterminés, on choisit des modalités de polymérisation (notamment type de polymérisation, et par exemple choix de la longueur d'onde dans le cas d'une photo polymérisation). On opère la polymérisation en question. Suivant une première option, on mesure l'évolution de la viscosité du matériau organique au cours de l'exposition de sorte à identifier un niveau de polymérisation (correspondant à une dose) auquel une viscosité suffisante est atteinte pour limiter ou supprimer la cinétique de démouillage. Suivant une deuxième option, alternative ou cumulative à la première, on réalise plusieurs expériences sur des échantillons distincts avec des doses croissantes, en suivant le procédé de l'invention, c'est-à-dire en opérant l'application de la dose de polymérisation durant la phase de revêtement par centrifugation. Cela permet d'identifier, ou pour le moins d'encadrer, un niveau de dose nécessaire et suffisant pour limiter ou supprimer le démouillage, durant un temps prédéterminé.

D'une manière générale, le demandeur a pu constater qu'il était possible de fixer l'état de couverture complet de la couche 3 de cette manière, au cours du temps, et même sans limite de temps, en particulier avec les paramètres de polymérisation donnés ci-dessus pour la phase de revêtement par centrifugation. Cependant, il n'est pas absolument nécessaire que l'état de couverture de la couche 3 soit définitivement fixé pour que la présente invention présente un intérêt et une efficacité industrielle. En effet, il peut être suffisant que l'état de couverture complet soit maintenu durant un temps correspondant à celui des phases ultérieures de fabrication jusqu'à une étape de polymérisation finale de la couche 3.

On peut notamment ralentir le retrait relativement aux procédés habituels sans polymérisation durant la rotation, en particulier de sorte à maintenir une vitesse de retrait du matériau avantageusement inférieure à 1 mm/heure, de préférence pour maintenir l'état de couverture complet durant un temps suffisant aux étapes ultérieures.

Au regard de la phase de polymérisation ainsi détaillée, on produit une couche 3 stabilisée comme à la figure 5. À la figure 6, un film polymère 4 est rapporté sur la face exposée de la couche 3. Il s'agit de préférence d'un film polymère ; cela peut être un film de marque Adwill D208^{®} employant une colle acrylique. Il est avantageux de ne pas avoir réalisé une polymérisation complète à l'étape précédente de sorte à autoriser la phase d'assemblage avec le film 4 en exploitant une capacité de polymérisation résiduelle du matériau de la couche 3. C'est ce qui est révélé à la figure 7 sur laquelle des flèches verticales symbolisent une nouvelle polymérisation, encore ici appelée polymérisation additionnelle du matériau de la couche 3. Cette polymérisation additionnelle est opérée sans rotation, la centrigugation ayant été stoppée après la polymérisation partielle. De préférence, le film 4 ne fait pas obstacle, ou pour le moins pas totalement, à cette phase supplémentaire de polymérisation. Ainsi, si cette dernière est une photo polymérisation, on choisira la matière du film 4 de sorte à ce qu'elle soit transparente, ou au moins partiellement transparente, dans la longueur d'onde considérée. Typiquement, il s'agira d'une photo polymérisation dans les mêmes conditions de lumière que la précédente, et notamment sous UV. Une polymérisation thermique reste possible en alternative.

De préférence, cette polymérisation additionnelle est complète de sorte que la couche 3 se trouve totalement polymérisée à son issue. La figure 8 schématise cette polymérisation complète par des hachures encore plus denses de la couche 3.

À ce stade, l'ensemble solidaire formé du film 4 et de la couche 3 peut être enlevé du moule maître 1, en particulier par une opération de pelage.

## Revendications

1. Procédé de fabrication d'un moule de lithographie pour impression nanométrique, comprenant successivement:
- un dépôt d'une couche (3) comprenant un matériau liquide polymérisable sur une surface de conformation (11) située sur une face d'un moule maitre, le dépôt comprenant un étalement du matériau par revêtement par centrifugation de sorte à atteindre un état de couverture de la couche (3) sur toute la surface de conformation (11) ;
- une polymérisation du matériau de la couche (3) tout en poursuivant la centrifugation ;
- un placement d'un film (4) polymère sur la couche (3).

2. Procédé selon la revendication 1, dans lequel la polymérisation est une polymérisation partielle.

3. Procédé selon la revendication 2, dans lequel la polymérisation partielle est suivie, après arrêt de la centrifugation, d'une polymérisation additionnelle du matériau.

4. Procédé selon la revendication 3, dans lequel la polymérisation additionnelle est configurée pour polymériser totalement le matériau.

5. Procédé selon l'une des revendications 3 et 4, dans lequel le placement d'un film (4) polymère est opéré sur la face exposée de la couche (3), avant la polymérisation additionnelle.

6. Procédé selon l'une des revendications précédentes, dans lequel la polymérisation est une polymérisation thermique.

7. Procédé selon l'une des revendications 1 à 5, dans lequel la polymérisation est une photo polymérisation.

8. Procédé selon la revendication 7, dans lequel la photo polymérisation est opérée en appliquant au matériau une dose comprise entre 5 et 10% de la dose de polymérisation totale de la couche (3).

9. Procédé selon l'une des revendications précédentes, dans lequel la polymérisation est configurée pour atteindre un niveau de polymérisation au moins suffisant pour obtenir une vitesse de retrait du matériau qui est inférieure ou égale à 1 mm/heure.

10. Procédé selon l'une des revendications précédentes, comprenant un dépôt d'un revêtement antiadhésif (2) sur la surface de conformation (11) avant le dépôt de la couche (3).

## Patentansprüche

1. Verfahren zur Herstellung einer Nanoprägelithografieform, das nacheinander umfasst:
- Abscheiden einer Schicht (3), die ein flüssiges polymerisierbares Material umfasst, auf einer Anformfläche (11), die sich auf einer Seite einer Master-Form befindet, wobei das Abscheiden ein Verteilen des Materials durch Schleuderbeschichten umfasst, sodass ein Zustand der Abdeckung mit der Schicht (3) auf der gesamten Anformfläche (11) erreicht wird;
- Polymerisieren des Materials der Schicht (3) bei gleichzeitigem Fortsetzen des Schleuderns;
- Anbringen eines Polymerfilms (4) auf der Schicht (3).

2. Verfahren nach Anspruch 1, wobei es sich bei dem Polymerisieren um eine teilweise Polymerisation handelt.

3. Verfahren nach Anspruch 2, wobei der teilweisen Polymerisation nach dem Stoppen des Schleuderns eine zusätzliche Polymerisation des Materials folgt.

4. Verfahren nach Anspruch 3, wobei die zusätzliche Polymerisation so ausgelegt ist, dass sie das Material vollständig polymerisiert.

5. Verfahren nach einem der Ansprüche 3 und 4, wobei das Anbringen eines Polymerfilms (4) auf der freiliegenden Seite der Schicht (3) vor der zusätzlichen Polymerisation ausgeführt wird.

6. Verfahren nach einem der vorstehenden Ansprüche, wobei es sich bei der Polymerisation um eine thermische Polymerisation handelt.

7. Verfahren nach einem der Ansprüche 1 bis 5, wobei es sich bei der Polymerisation um eine Photopolymerisation handelt.

8. Verfahren nach Anspruch 7, wobei die Photopolymerisation unter Aufbringen einer Dosis im Bereich zwischen 5 und 10 % der Dosis für die vollständige Polymerisation der Schicht (3) auf das Material ausgeführt wird.

9. Verfahren nach einem der vorstehenden Ansprüche, wobei die Polymerisation so ausgelegt ist, dass ein Polymerisationsgrad erreicht wird, der mindestens ausreicht, um eine Abfließgeschwindigkeit des Materials von kleiner als oder gleich 1 mm/Stunde zu erhalten.

10. Verfahren nach einem der vorstehenden Ansprüche, das vor dem Abscheiden der Schicht ein Abscheiden einer Antihaftbeschichtung (2) auf der Anformfläche (11) umfasst.

## Claims

1. A method for manufacturing a lithography mold for nanoimprinting, comprising successively:
- a deposition of a layer (3) comprising a polymerisable liquid material on a shaping surface (11) located on one face of a master mold, the deposition comprising a spreading of the material by spin coating so as to reach a state of coverage of the layer (3) over the entire shaping surface (11);
- a polymerisation of the material of the layer (3) while continuing the centrifugation;
- a placement of a polymer film (4) on the layer (3).

2. The method according to claim 1, wherein the polymerisation is a partial polymerisation.

3. The method according to claim 2, wherein the partial polymerisation is followed, after stopping the centrifugation, by an additional polymerisation of the material.

4. The method according to claim 3, wherein the additional polymerisation is configured to fully polymerise the material.

5. The method according to one of claims 3 and 4, wherein the placement of a polymer film (4) is operated on the exposed face of the layer (3), before the additional polymerisation.

6. The method according to one of the preceding claims, wherein the polymerisation is a thermal polymerisation.

7. The method according to one of claims 1 to 5, wherein the polymerisation is a photopolymerisation.

8. The method according to claim 7, wherein the photopolymerisation is operated by applying, to the material, a dose comprised between 5 and 10% of the total polymerisation dose of the layer (3).

9. The method according to one of the preceding claims, wherein the polymerisation is configured to reach a level of polymerisation which is at least sufficient to obtain a material shrinkage rate which is less than or equal to 1 mm/hour.

10. The method according to one of the preceding claims, comprising a deposition of a non-stick coating (2) on the shaping surface (11) before depositing the layer (3).
